(19) Europäisches Patentamt / European Patent Office / Office européen des brevets

(11) **EP 2 845 887 B1**

(12) **EUROPEAN PATENT SPECIFICATION**

(45) Date of publication and mention of the grant of the patent:
**28.07.2021 Bulletin 2021/30**

(51) Int Cl.:
*C09D 153/00* ^(2006.01)      *C08L 53/00* ^(2006.01)
*G03F 7/16* ^(2006.01)      *B29K 96/04* ^(2006.01)
*B05D 3/00* ^(2006.01)      *B29C 39/00* ^(2006.01)
*B29K 33/00* ^(2006.01)      *B29K 105/00* ^(2006.01)
*B29L 7/00* ^(2006.01)      *G03F 7/00* ^(2006.01)
*B29K 25/00* ^(2006.01)

(21) Application number: **14183681.7**

(22) Date of filing: **05.09.2014**

(54) **PROCESS FOR CONTROLLING THE PERIOD OF A NANOSTRUCTURED ASSEMBLAGE COMPRISING A BLEND OF BLOCK COPOLYMERS**

VERFAHREN ZUM STEUERN DER PERIODE VON NANOSTRUKTURVERBINDUNGEN, DIE EINE MISCHUNG VON BLOCKCOPOLYMEREN ENTHALTEN

PROCÉDÉ DE CONTRÔLE DE LA PÉRIODE D'UN ASSEMBLAGE NANOSTRUCTURÉ COMPRENANT UN MÉLANGE DE COPOLYMÈRES À BLOCS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.09.2013 FR 1358625**
**25.02.2014 FR 1451491**

(43) Date of publication of application:
**11.03.2015 Bulletin 2015/11**

(73) Proprietors:
• **ARKEMA FRANCE**
**92700 Colombes (FR)**
• **CENTRE NATIONAL DE LA RECHERCHE SCIENTIFIQUE**
**75794 Paris Cedex 14 (FR)**
• **UNIVERSITE DE BORDEAUX**
**33000 Bordeaux (FR)**
• **Institut Polytechnique de Bordeaux**
**33402 Talence Cedex (FR)**

(72) Inventors:
• **NAVARRO, Christophe**
**64100 BAYONNE (FR)**
• **CHEVALIER, Xavier**
**38100 GRENOBLE (FR)**
• **NICOLET, Celia**
**64300 ORTHEZ (FR)**
• **ILIOPOULOS, Ilias**
**75012 PARIS (FR)**
• **TIRON, Raluca**
**38950 SAINT-MARTIN-LE-VINOUX (FR)**
• **FLEURY, Guillaume**
**33000 BORDEAUX (FR)**
• **HADZIIOANNOU, Georges**
**33850 LEOGNAN (FR)**

(74) Representative: **Arkema Patent**
**Arkema France**
**DRD-DPI**
**420, rue d'Estienne d'Orves**
**92705 Colombes Cedex (FR)**

(56) References cited:
**WO-A2-2009/151834      US-A1- 2013 209 696**

• **HIROFUMI KITANO ET AL: "Control of the Microdomain Orientation in Block Copolymer Thin Films with Homopolymers for Lithographic Application", LANGMUIR, vol. 23, no. 11, 1 May 2007 (2007-05-01), pages 6404-6410, XP055110353, ISSN: 0743-7463, DOI: 10.1021/la0637014**
• **None**

**Description**

The present invention relates to a process for controlling the period of a nanostructured assemblage comprising a blend of block copolymers which is deposited on a surface or in a mold. Block copolymers are characterized by the possession of at least one of the constituent monomers respectively of each of the blocks of the block copolymers identical but exhibit different molecular weights. The control process is targeted at obtaining thicknesses of films or objects, with few nanostructuring defects, which are sufficiently great for the treated surface to be able to be used as mask for applications in microelectronics or for the objects resulting therefrom to exhibit previously unpublished mechanical, acoustic or optical characteristics.

The term "period" is understood to mean the minimum distance separating two neighboring domains having the same chemical composition, separated by a domain having a different chemical composition.

For reasons of simplicity in the reading of the text which follows, reference will be made to period of some or other block copolymer or period of the blend of block copolymers, once the block copolymer or blend of block copolymers is deposited on a surface or formed, for example in a mold.

Due to their ability to develop a nanostructure, the use of block copolymers in the fields of materials and electronics or optoelectronics is now well known. This novel technology allows access to advanced processes for the manufacture of objects and for nanolithographic preparation with resolutions in terms of domain size ranging from a few nanometers to several tens of nanometers.

It is in particular possible to structure the arrangement of the blocks making up the copolymers at scales far below 100 nm. Unfortunately, it is difficult on the industrial scale to reproduce nanolithographic objects or preparations from one manufacture to another with identical domain dimensions.

In the case of the manufacture of objects, their properties, whether mechanical, acoustic or optical, are conditioned by the size of the domains. It is thus important to be able to finely adjust the size of the domains, which is linked to the control of the period.

In the case of nanolithography, the desired structuring (for example, generation of the domains perpendicular to the surface) requires specific conditions, such as the preparation of the surface (for example, deposition of a "neutralization" underlayer) but also such as the composition of the block copolymer. Whether it is the chemical nature of the blocks, the ratio by weight of the blocks or their length, an optimization is generally required in order to obtain a morphology as close as possible to the requirements of industry, without defect, and reproducibly. The period of a block copolymer can change according to the conditions of synthesis of the copolymer according to the addition of homopolymer(s) to the block copolymer, or also by blending block copolymers having different periods.

However, the variation in the synthesis conditions is only rather unattractive as a slight variation in monomer units from one synthesis to another can bring about a strong variation in the period of the polymer (Proc. of SPIE, Vol. 8680, Alternative Lithographic Technologies V, 86801Z, 2013, Lawson et al.), thus rendering their application rather hazardous in microelectronics processes, where a slight variation in size of the devices brings about sizeable changes with regard to their physical properties. The addition of homopolymer(s) to the block copolymer is an elegant process. However, if just one homopolymer is added, variations with regard to the final morphology of the blend may occur before the desired period is obtained. The blend of block copolymers exhibiting different periods is also a possibility in order to obtain a targeted period. However, it is known that macroscopic phase separations and also variations with regard to the final morphology may occur if the starting components are not correctly chosen (G. Hadziioannou et al., Macromolecules, 1982, 15, 267-271, D. Yamaguchi et al., Macromolecules, 2001, 34, 6495-6505, E. Sivaniah et al., Macromolecules, 2008, 41, 2584-2592). Furthermore, the very great majority of the studies reported with regard to blends of this type are devoted to the behavior of bulk systems, with techniques for self-organization of the polymer (shearing, long heating times, and the like) which are not very compatible with the current processes for the manufacture of objects or microelectronics. The few studies concern blends organized as thin films relating either to copolymer systems not very favorable to use with regard to the manufacture of objects or, in the specific case of microelectronic tracks, exhibiting problems of contamination of the polymer (presence, in one of the blocks of the block copolymer, of chemical groups which easily complex metal cations), of transfer of the film into the substrate requiring a metallization of one of the blocks, which is incompatible with certain technologies, such as CMOS "Complementary Metal Oxide Semi-conductor", which more is in the case of on the whole cylindrical or spherical morphologies but virtually impossible with morphologies of the type of cylinders perpendicular to the substrate (X. Zhang et al., Macromolecules, 2011, 44, 9752-9757), or relating to films which are still too thick (L. Kane et al., Macromolecules, 1996, 29, 8862-8870, S. Koizumi et al., Macromolecules, 1994, 27, 4371-4381), with the result that very little information is available with regard to systems organized perpendicularly with respect to the surface which can be used for applications in lithography. Be that as it may, both in bulk and in "thin" films, the studies differ with regard to the change in the period of the blend as a function of the relative proportion of its constituents, this change, ranging from a vaguely linear variation to a sigmoidal variation, it being possible for the period of the blend to be in some cases greater than that of its pure constituent of greatest period. It is also important to note that, whatever the process used to control the period (homopolymer, synthesis conditions, blends of block copolymers), when the block copolymers are organized as thin films, typically thicknesses of less than 100 nm, their period varies by a few % following the thickness of the films as a result of the proximity of the surface, which invariably brings about a loss with regard to the control over the latter.

The present invention is based on the use of blends of block copolymers with different molecular weights but for which at least one of the constituent monomers respectively of each of the blocks of the block copolymers is identical. Taken in isolation, each block copolymer deposited on a surface or injected into a mold is characterized by a period.

The applicant company has now discovered that blends of block copolymers with different molecular weights but having at least one of the constituent monomers respectively of each of the blocks of the block copolymers identical, each exhibiting a different period, provide the following advantages:

- Films obtained by blending block copolymers can be organized perpendicularly without defects for greater thicknesses than those of a pure block copolymer with an equivalent period, thus rendering these films much more advantageous for being able to be used as masks for lithography,
- For an unvarying film thickness, the period of the blend follows a linear relationship as a function of the relative proportion of each of its constituents. The period of the blend at a given film thickness can thus be estimated with an extremely low error by simply knowing the period of the copolymers constituting it for the same film thickness, with the condition that all the block copolymers exhibit the same nanostructure (cylindrical orthogonal or parallel to the surface, lamellar orthogonal or vertical to the surface, spherical).
- In order to cover a given range of periods advantageous in electronics, instead of using two block copolymers, the relative period of which corresponds to each end of the desired period range, better control over the period of the blend is obtained by the use of block copolymers of closer period. Finally, the process of the invention, consisting in blending copolymers of different molecular weights, makes it possible to carry out the annealing necessary to structure the block copolymers at temperatures lower by 30 to 50°C with respect to the temperature used when just one block copolymer exhibiting the same period that the blended copolymers of low dispersity (typically less than 1.1) is used, or in shorter times.

These advantages are also transposable to blends of block copolymers formed in the form of objects, obtained, for example, by injection into a mold or extrusion in the form of sheets. This makes possible precise refining of the optical, acoustic or mechanical properties and the achievement of a compromise in combined properties, such as good transparency and high impact strength.

Summary of the invention:

The invention relates to a process for controlling the period of a nanostructured assemblage of a blend of block copolymers, the period, expressed in nm, following the following equation:

$$L0 = \frac{\sum_{i=1}^{n} f_i \times L0_i}{\sum_{i=1}^{n} f_i}$$

Where $f_i$ being the volumic fraction of the i block copolymer in the i solution and $L0_i$ being the period of the i block copolymer after solvent evaporation, the fraction by volume $f_i$ being defined by the IUPAC as being the volume of the component i in the i solution divided by the sum of the volumes of all the components in solution used to manufacture this blend,

this blend comprising n block copolymers with different molecular weights but for which at least one of the constituent monomers respectively of each of the blocks of the block copolymers is identical, n being a whole number between 2 and 5, comprising the following stages:

- blend comprising block copolymers in solution,

- deposition of this solution of blend on a surface or in a mold,

- annealing.

It should be consider that with n>5 one would still be within the scope of the invention but it would have less industrial interest.

Detailed description:

The term "surface" is understood to mean a surface which can be flat or non-flat. In the latter case, it can be the internal surface of a mold, which case will be considered for the manufacture of an object with filling of the mold with said blend.

The term "annealing" is understood to mean a heating stage which makes possible the evaporation of the solvent, when it is present, and which allows the establishment of the desired nanostructuring.

The nanostructuring of a block copolymer of a surface treated by the process of the invention can take the forms such as cylindrical (hexagonal symmetry (*primitive hexagonal* lattice symmetry *"6 mm"*) according to the Hermann-Mauguin notation, or tetragonal symmetry (*primitive tetragonal* lattice symmetry *"4 mm"*)), spherical (hexagonal symmetry (*primitive hexagonal* lattice symmetry *"6 mm"* or *"6/mmm"*), or tetragonal symmetry (*primitive tetragonal* lattice symmetry *"4 mm"*), or cubic symmetry (lattice symmetry $m\bar{3}m$)), lamellar or gyroidal. Preferably, and as non limiting choice, the preferred form which the nanostructuring takes is of the hexagonal cylindrical type or lamellar.

The process for the self-assembling of block copolymers on a surface treated according to the invention is governed by thermodynamic laws. When the self-assembling results in a morphology of cylindrical type, each cylinder is surrounded by 6 equidistant neighboring cylinders if there is no defect. Several types of defects can thus be identified. The first type is based on the evaluation of the number of neighbors around a cylinder which constitutes the arrangement of the block copolymer, also known as coordination number defects. If five or seven cylinders surround the cylinder under consideration, a coordination number defect will be regarded as being present. The second type of defect considers the mean distance between the cylinders surrounding the cylinder under consideration [W.Li, F.Qiu, Y.Yang and A.C.Shi, Macromolecules, 43, 2644 (2010); K. Aissou, T. Baron, M. Kogelschatz and A. Pascale, Macromol., 40, 5054 (2007); R. A. Segalman, H. Yokoyama and E. J. Kramer, Adv. Matter., 13, 1152 (2003); R. A. Segalman, H. Yokoyama and E. J. Kramer, Adv. Matter., 13, 1152 (2003)]. When this distance between two neighbors is greater than two % of the mean distance between two neighbors, a defect will be regarded as being present. In order to determine these two types of defects, use is conventionally made of the associated Voronoi constructions and Delaunay triangulations. After binarization of the image, the center of each cylinder is identified. The Delaunay triangulation subsequently makes it possible to identify the number of first-order neighbors and to calculate the mean distance between two neighbors. It is thus possible to determine the number of defects. This counting method is described in the paper by Tiron et al. (J. Vac. Sci. Technol. B, 29(6), 1071-1023, 2011).

A final type of defect relates to the angle of cylinders of the block copolymer which is deposited on the surface. When the block copolymer is no longer perpendicular to the surface but lying down parallel to the latter or with an angle below 90°, a defect of orientation will be regarded as having appeared.

The process of the invention makes it possible to obtain nanostructured assemblages in the form of films with a minimum of defects of orientation, of coordination number or of distance and large microcrystalline surfaces.

The blends of block copolymers can be prepared either using a solvent, when it is desired to manufacture a thin film, after deposition on a surface and evaporation of the solvent, or with flowing or with melting, when it is desired to manufacture an object after injection, for example into a mold, in the presence or absence of shearing.

Any block copolymer, whatever its associated morphology, can be used in the context of the invention, whether diblock, linear or star-branched triblock or linear, comb-shaped or star-branched multiblock copolymers are involved, for which at least one of the constituent monomers respectively of each of the blocks of the block copolymers is identical, but exhibiting different molecular weights. Preferably, diblock or triblock copolymers and more preferably diblock copolymers are involved.

It will be possible, in the context of the invention, to blend n block copolymers, n being an integer between 2 and 5, limits included. Preferably, n is equal to 2 or 3 and more preferably n is equal to 2. However, it should be considered that with n>5 one would still be within the scope of the invention but it would have less industrial interest.

They can be synthesized by any technique known to a person skilled in the art, among which may be mentioned polycondensation, ring opening polymerization or anionic, cationic or radical polymerization, it being possible for these techniques to be controlled or uncontrolled with the possibility to combine several polymerization technics (for example anionic for one block and radical for an other block). When the copolymers are prepared by radical polymerization, the latter can be controlled by any known technique, such as NMP ("Nitroxide Mediated Polymerization"), RAFT ("Reversible Addition and Fragmentation Transfer"), ATRP ("Atom Transfer Radical Polymerization"), INIFERTER ("Initiator-Transfer-Termination"), RITP ("Reverse Iodine Transfer Polymerization") or ITP ("Iodine Transfer Polymerization").

According to a preferred form of the invention, the copolymers are prepared by controlled radical polymerization, more particularly still by nitroxide mediated polymerization, the nitroxide being in particular N-(tert-butyl)-1-diethylphosphono-2,2-dimethylpropyl nitroxide.

According to a second preferred form of the invention, the copolymers are prepared by anionic polymerization.

When the polymerization is carried out in radical fashion, the constituent monomers of the block copolymers will be chosen from the following monomers: at least one vinyl, vinylidene, diene, olefinic, allyl or (meth)acrylic monomer. This monomer is more particularly chosen from vinylaromatic monomers, such as styrene or substituted styrenes, in particular $\alpha$-methylstyrene, silylated styrenes, acrylic monomers, such as acrylic acid or its salts, alkyl, cycloalkyl or aryl acrylates, such as methyl, ethyl, butyl, ethylhexyl or phenyl acrylate, hydroxyalkyl acrylates, such as 2-hydroxyethyl acrylate, ether alkyl acrylates, such as 2-methoxyethyl acrylate, alkoxy- or aryloxypolyalkylene glycol acrylates, such as methoxypolyethylene glycol acrylates, ethoxypolyethylene glycol acrylates, methoxypolypropylene glycol acrylates, methoxypolyethylene glycol-polypropylene glycol acrylates or their mixtures, aminoalkyl acrylates, such as 2-(dimethylamino)ethyl acrylate (ADAME), fluoroacrylates, silylated acrylates, phosphorus-comprising acrylates, such as alkylene glycol acrylate phosphates, glycidyl acrylate or dicyclopentenyloxyethyl acrylate, methacrylic monomers, such as methacrylic acid or its salts, alkyl, cycloalkyl, alkenyl or aryl methacrylates, such as methyl (MMA), lauryl, cyclohexyl, allyl, phenyl or naphthyl methacrylate, hydroxyalkyl methacrylates, such as 2-hydroxyethyl methacrylate or 2-hydroxypropyl methacrylate, ether alkyl methacrylates, such as 2-ethoxyethyl methacrylate, alkoxy- or aryloxypolyalkylene glycol methacrylates, such as methoxypolyethylene glycol methacrylates, ethoxypolyethylene glycol methacrylates, methoxypolypropylene glycol methacrylates, methoxypolyethylene glycol-polypropylene glycol methacrylates or their mixtures, aminoalkyl methacrylates, such as 2-(dimethylamino)ethyl methacrylate (MADAME), fluoromethacrylates, such as 2,2,2-trifluoroethyl methacrylate, silylated methacrylates, such as 3-methacryloyloxypropyltrimethylsilane, phosphorus-comprising methacrylates, such as alkylene glycol methacrylate phosphates, hydroxyethylimidazolidone methacrylate, hydroxyethylimidazolidinone methacrylate or 2-(2-oxo-1-imidazolidinyl)ethyl methacrylate, acrylonitrile, acrylamide or substituted acrylamides, 4-acryloylmorpholine, N-methylolacrylamide, methacrylamide or substituted methacrylamides, N-methylolmethacrylamide, methacrylamidopropyltrimethylammonium chloride (MAPTAC), glycidyl methacrylate, dicyclopentenyloxyethyl methacrylate, itaconic acid, maleic acid or its salts, maleic anhydride, alkyl or alkoxy- or aryloxypolyalkylene glycol maleates or hemimaleates, vinylpyridine, vinylpyrrolidinone, (alkoxy)poly(alkylene glycol) vinyl ethers or divinyl ethers, such as methoxypoly(ethylene glycol) vinyl ether or poly(ethylene glycol) divinyl ether, olefinic monomers, among which may be mentioned ethylene, butene, hexene and 1-octene, diene monomers, including butadiene or isoprene, as well as fluoroolefinic monomers and vinylidene monomers, among which may be mentioned vinylidene fluoride, alone or as a mixture of at least two abovementioned monomers.

Preferably, the block copolymers are composed of a block copolymer, one of the blocks of which comprises a styrene monomer and the other block of which comprises a methacrylic monomer; more preferably, the block copolymers are composed of a block copolymer, one of the blocks of which comprises styrene and the other block of which comprises methyl methacrylate.

In a preferred context of the invention, use will be made of an anionic polymerization process in a nonpolar solvent and preferably toluene, as described in the patent EP 0 749 987, and which involves a micromixer. Preference will be given to the monomers chosen from the following entities: at least one vinyl, vinylidene, diene, olefinic, allyl or (meth)acrylic monomer. These monomers are more particularly chosen from vinylaromatic monomers, such as styrene or substituted styrenes, in particular $\alpha$-methylstyrene, silylated styrenes, acrylic monomers, such as alkyl, cycloalkyl or aryl acrylates, such as methyl, ethyl, butyl, ethylhexyl or phenyl acrylate, ether alkyl acrylates, such as 2-methoxyethyl acrylate, alkoxy- or aryloxypolyalkylene glycol acrylates, such as methoxypolyethylene glycol acrylates, ethoxypolyethylene glycol acrylates, methoxypolypropylene glycol acrylates, methoxypolyethylene glycol-polypropylene glycol acrylates or their mixtures, aminoalkyl acrylates, such as 2-(dimethylamino)ethyl acrylate (ADAME), fluoroacrylates, silylated acrylates, phosphorus-comprising acrylates, such as alkylene glycol acrylate phosphates, glycidyl acrylate or dicyclopentenyloxyethyl acrylate, alkyl, cycloalkyl, alkenyl or aryl methacrylates, such as methyl (MMA), lauryl, cyclohexyl, allyl, phenyl or naphthyl methacrylate, ether alkyl methacrylates, such as 2-ethoxyethyl methacrylate, alkoxy- or aryloxypolyalkylene glycol methacrylates, such as methoxypolyethylene glycol methacrylates, ethoxypolyethylene glycol methacrylates, methoxypolypropylene glycol methacrylates, methoxypolyethylene glycol-polypropylene glycol methacrylates or their mixtures, aminoalkyl methacrylates, such as 2-(dimethylamino)ethyl methacrylate (MADAME), fluoromethacrylates, such as 2,2,2-trifluoroethyl methacrylate, silylated methacrylates, such as 3-methacryloyloxypropyltrimethylsilane, phosphorus-comprising methacrylates, such as alkylene glycol methacrylate phosphates, hydroxyethylimidazolidone methacrylate, hydroxyethylimidazolidinone methacrylate or 2-(2-oxo-1-imidazolidinyl)ethyl methacrylate, acrylonitrile, acrylamide or substituted acrylamides, 4-acryloylmorpholine, N-methylolacrylamide, methacrylamide or substituted methacrylamides, N-methylolmethacrylamide, methacrylamidopropyltrimethylammonium chloride (MAPTAC), glycidyl methacrylate, dicyclopentenyloxyethyl methacrylate, maleic anhydride, alkyl or alkoxy- or aryloxypolyalkylene glycol maleates or hemimaleates, vinylpyridine, vinylpyrrolidinone, (alkoxy)poly(alkylene glycol) vinyl ethers or divinyl ethers, such as methoxypoly(ethylene glycol) vinyl ether or poly(ethylene glycol) divinyl ether, olefinic monomers, among which may be mentioned ethylene, butene, hexene and 1-octene, diene monomers, including butadiene or isoprene, as well as fluoroolefinic monomers and vinylidene monomers, among which may be mentioned vinylidene fluoride, lactones, lactides, glycolides, cyclic carbonates or siloxanes, if appropriate protected in order to be compatible with the anionic polymerization processes, alone or as a mixture of at least two abovementioned monomers.

According to an alternative form of the invention, consideration will be given to block copolymer blends, one of the blocks of which comprises styrene and at least one comonomer X, the other block of which comprising methyl methacrylate and at least one comonomer Y, X being chosen from the following entities: styrene, which is hydrogenated or partially hydrogenated, cyclohexadiene, cyclohexene, styrene substituted by one or more fluoroalkyl or silylated alkyl groups, or their mixtures, in proportions by weight of X ranging from 1% to 99% and preferably from 2% to 20%, with respect to the block comprising styrene; Y being chosen from the following entities: fluoroalkyl (meth)acrylate, particularly trifluoroethyl methacrylate, dimethylaminoethyl (meth)acrylate, globular acrylates, such as isobornyl acrylate or halogenated isobornyl acrylate, halogenated alkyl acrylate, naphthyl acrylate, trimethylsilyl acrylate, polyhedral oligomeric silsesquioxane acrylate, which can comprise a fluorinated group, or their mixtures, in proportions by weight of Y ranging from 1% to 99% and preferably from 2% to 20%, with respect to the block comprising methyl methacrylate.

The block copolymers used in the invention each exhibit the following characteristics:

A number-average molecular weight of between 1000 and 300 000 g/mol and preferably between 10 000 and 250 000 kg/mol, more preferably between 32000 and 150000 and a dispersity index of between 1 and 3 and preferably of between 1 and 2.

In the case of a blend of two block copolymers, the proportion by weight of a block copolymer in the blend of block copolymers varies from 1% to 99%.

According to a first preferred form of the invention using two block copolymers, block copolymers will be chosen for which the difference in period is between 25 and 40 nm. This specific choice favors the production of films with a minimum of defects while retaining control of the period of the blended block copolymers maximum of 1.4 nm when comparing calculated and experimental data.

According to a second preferred form of the invention using two block copolymers, block copolymers will be chosen for which the difference in period is between 1 and 25 nm and preferably between 13 and 17 nm. This specific choice favors the production of films with very precise control of the period of the blended block copolymers, typically less than 0.6 nm when comparing calculated and experimental data, and with a level of defects to be compatible with the applications under consideration.

The blends of copolymers used in the context of the invention can be produced either from dry powders of each block copolymer or from solutions of block copolymers dissolved in one or more solvents, among which may be mentioned propylene glycol monomethyl ether acetate (PGMEA), ethoxyethyl propionate, anisole or toluene. Preferably, the solvent is PGMEA.

The blends of copolymers used in the context of the invention can comprise one or more additives, such as a surfactant, UV stabilizer or antioxidant, a compound which makes possible crosslinking or a UV-sensitive initiator.

When a blend of n block copolymers is used, starting from solutions of block copolymers, the period of the blend deposited on a surface, expressed in nm, after solvent evaporation, can be calculated according to the following formula:

$$L0 = \frac{\sum_{i=1}^{n} f_i \times L0_i}{\sum_{i=L0_i}^{n} f_i}$$

Where $f_i$ being the volumic fraction of the i block copolymer in the i solution and $L0_i$ being the period of the i block copolymer after solvent evaporation.

The fraction by volume $f_i$ is defined by the IUPAC as being the volume of the component i in the i solution divided by the sum of the volumes of all the components in solution used to manufacture this blend. All solution of the i block copolymer have the same concentration for simplicity, but different concentration could be used and the formula adapted accordingly.

When a blend of two block copolymers A and B is used, the period of the blend deposited on a surface, expressed in nm, can be calculated according to the following formula:

$$\texttt{L0 blend} = \frac{(f_A \times L0_A) + (f_B \times L0_B)}{f_A + f_B}$$

where $f_A$ and $f_B$ are the fractions by volume of the two solutions of block copolymers A and B, and $L0_A$ and $L0_B$ are the periods of the two block copolymers A and B deposited alone on a surface, expressed in nm.

The equation could also be expressed as followed:

$$\texttt{L0 blend} = \frac{\texttt{SCA solution} \times \texttt{L0A} + \texttt{SCB solution} \times \texttt{L0B}}{\texttt{SC of mixed A and B solution}}$$

Where SCA and SCB are solid content of A and B solution.

In the present invention, the fractions by volume $f_A$ or $f_B$ are the volume of the solution of the component A or B divided by the sum of the volumes of the solutions of the components A and B used to manufacture this blend.

The blend of block copolymers can be used in various applicative processes, such as the manufacture of objects, nanostructured film at nanometer scale, lithography (lithography masks), the manufacture of membranes, the functionalization and coating of surfaces, the manufacture of inks and composites, the nanostructuring of surfaces, the manufacture of transistors, diodes, or organic memory cells.

The process of the invention makes it possible to obtain films, the thicknesses of which are greater than or equal to 10 nm and less than 400 nm, and preferably of between 40 and 400 nm and more preferably between 40 and 150 nm.

The invention relates in particular to the use of the process which is a subject matter of the invention to manufacture lithography objects or masks, to the masks and objects obtained, and to the films of block copolymer structured at a nanometer scale.

In the case of lithography, the desired structuring (for example, generation of the domains perpendicular to the surface) requires, however, the preparation of the surface on which the blend of polymers is deposited for the purpose of controlling the surface energy. Among the known possibilities, a random copolymer, the monomers of which can be identical, in all or part, to those used in the block copolymer which it is desired to deposit, is deposited on the surface. In a pioneering paper, Mansky et al. (Science, Vol. 275, pages 1458-1460, 1997) give a good description of this technology, now well known to a person skilled in the art.

Mention may be made, among the favored surfaces, of the surfaces composed of silicon, the silicon exhibiting a native or thermal oxide layer, germanium, platinum, tungsten, gold, titanium nitrides, graphenes, BARC (Bottom Anti-Reflective Coating) or any other antireflective layer used in lithography.

The surfaces can be said to be "free" (flat and homogeneous surface, both from a topographical and from a chemical viewpoint) or can exhibit structures for guidance of the block copolymer "pattern", whether this guidance is of the chemical guidance type (known as "guidance by chemical epitaxy") or physical/topographical guidance type (known as "guidance by graphoepitaxy").

Once the surface has been prepared, a solution of the blend of block copolymers is deposited and then the solvent is evaporated according to techniques known to a person skilled in the art, such as, for example, the spin coating, doctor blade, knife system or slot die system technique, but any other technique can be used, such as dry deposition, that is to say deposition without involving a predissolution.

A heat treatment or treatment by solvent vapor, a combination of the two treatments, or any other treatment known to a person skilled in the art which allows the blend of block copolymers to become correctly organized, is subsequently carried out.

The process of the invention makes it possible to obtain films with fewer defects, whether these are defects of orientation of the block copolymers deposited, coordination number defects or distance defects. Thus, the process of the invention makes possible the manufacture of films with greater monocrystalline surfaces compared with those obtained with a single block copolymer of low dispersity (typically less than 1.1). The term "monocrystalline surface" is understood to mean a surface where the morphology of the block copolymer (or of the block copolymers) deposited is perfectly ordered, without defect of orientation, of distance or of coordination number, exhibiting a long-range periodic or quasiperiodic translational order, typically several times the intrinsic period/unit cell of the block copolymer (or of the block copolymers), whatever the chosen direction of the surface, and the boundary of which is delimited by defects, whether defects of orientation, of distance or of coordination number.

The following examples nonlimitingly illustrate the scope of the invention:

Three solutions of polymers are used (at 1% in PGMEA), available from Arkema under the name Nanostrength EO®, specifically the C22, C35 and C50 grades, respectively exhibiting periods, once individually deposited on a surface, of 23.05, 34.3 and 49.7 nm for equivalent film thicknesses.

These block copolymers are PS-*b*-PMMA copolymers prepared according to a protocol described in EP 0 749 987, EP 0 749 987 and EP 0 524 054, with recovery of the block copolymer under consideration by precipitation from a nonsolvent on conclusion of the synthesis, such as an 80/20 by volume mixture of cyclohexane/heptane.

They exhibit the following characteristics:

C22:

Mn = 35.5 kg/mol
Mw/Mn = 1.09
PS/PMMA ratio by weight = 69/31

C35:

Mn = 61.4 kg/mol
Mw/Mn = 1.09
PS/PMMA ratio by weight = 66.3/33.7

C50:

Mn = 104.8 kg/mol
Mw/Mn = 1.15
PS/PMMA ratio by weight = 64.3/35.7

After synthesis of the PS block, a sample is analysed by SEC (size exclusion chromatography) with PS standards. The block copolymer is also analysed by proton NMR to determine PS/PMMA ratio. Then the molecular weight of the bloc copolymer is calculated from PS ratio in the block copolymer and the molecular weight of the PS block. Finally, the dispersity is obtained from SEC with PS standards.

The molecular weights and the dispersity indices, corresponding to the ratio of weight-average molecular weight (Mw) to number-average molecular weight (Mn), are obtained by SEC (Size Exclusion Chromatography), using two Agilent 3 $\mu$m ResiPore columns in series, in a THF medium stabilized with BHT, at a flow rate of 1 ml/min, at 40°C, with samples at a concentration of 1 g/l, with prior calibration with graded samples of polystyrene using an Easical PS-2 prepared pack.

The PS/PMMA ratio by weight is obtained by proton NMR on a Bruker 400 device by integrating the 5 aromatic protons of the PS and the 3 protons of the methoxy of the PMMA.

Three solutions of PS-*b*-PMMA copolymers are prepared (at 1% by weight in PGMEA) using respectively the C22, C35 and C50 copolymers, respectively exhibiting periods, once individually deposited on a surface, of 23.05, 34.3 and 49.7 nm for equivalent film thicknesses.

Subsequently, these solutions of block copolymers will be called 23, 35 and 50.

The invention can also be carried out using other block copolymers of other origin.

Example 1:

The following blends are prepared:

23-35 Blends: in the proportions 3:1, 1:1 and 1:3 (volume/volume).
35-50 Blends: in the proportions 3:1, 1:1 and 1:3 (volume/volume).
23-50 Blends: in the proportions 3:1, 1:1 and 1:3 (volume/volume).

The solutions of block copolymers alone (23, 35 et 50) will also be considered.

The solutions are deposited on a surface in the following way:

Preparation of the surface, grafting to $SiO_2$:

Silicon wafers (crystallographic orientation {100}) are cut up manually into 3 x 4 cm pieces and cleaned by piranha treatment ($H_2SO_4/H_2O_2$ 2:1 (v:v)) for 15 minutes, then rinsed with deionized water and dried under a stream of nitrogen immediately before functionalization. The continuation of the procedure is that described by Mansky et al. (Science, 1997, 1458), with just one modification (the annealing is carried out under ambient atmosphere and not under vacuum).

A random PS-r-PMMA copolymer with a molecular weight of 12 280 g/mol and with a PS/PMMA ratio of 74/26, prepared by radical polymerization controlled using the NMP technology, according to a protocol described in WO20121400383, example 1 and example 2 (copolymer 11), allowing the neutralization of the surface, is dissolved in toluene in order to obtain 1.5% by weight solutions. This solution is dispensed by hand over a freshly cleaned wafer and then spread by spin coating at 700 revolutions/min in order to obtain a film with a thickness of approximately 90 nm. The substrate is then simply deposited on a heating plate, brought beforehand to the desired temperature, under ambient atmosphere for a variable time. The substrate is then washed by sonication in several toluene baths for a few minutes, in order to remove the ungrafted polymer from the surface, and then dried under a stream of nitrogen. It may be noted that, throughout this procedure, the toluene can be replaced without distinction by PGMEA.

Any other copolymer can be used, typically a random P(MMA-co-styrene) copolymer as used by Mansky, provided that the styrene and MMA composition is chosen to be appropriate for neutralization.

The solution of the block copolymer or blend of block copolymers (1% by weight in propylene glycol monomethyl ether acetate) is subsequently deposited by spin coating over the pretreated surface and then a thermal annealing is carried out at 230°C for at least 5 minutes in order to evaporate the solvent and to leave time for the morphology to become established.

The operation is carried out so that the thickness of the film of block copolymer or blend of block copolymers is equal to or greater than 40 nm and less than 400 nm, and preferably of between 40 and 150 nm. Typically, the solution to be deposited (1% in PGMEA) is deposited over a 2.7 x 2.7 cm sample by spin coating at 100 revolutions/min.

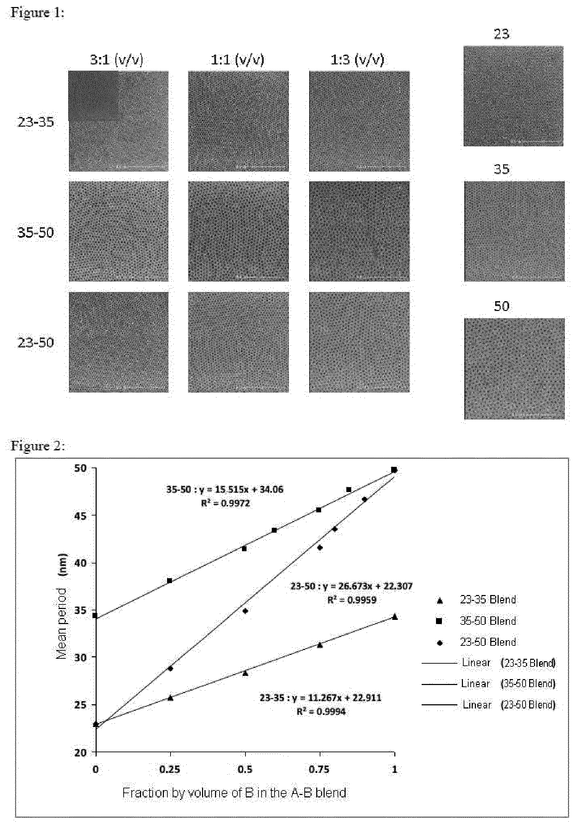

In figure 1, it is possible to visualize the assemblage results of the various samples of the blends of block copolymers and also of the block copolymers alone. These images are obtained by scanning electron microscopy carried out on a CD-SEM H9300 from Hitachi.

The periods of block copolymers or of their blends are measured in the following way:

The SEM images are processed via the "imageJ" multiplatform and open source software for image processing and analysis developed by the National Institutes of Health and available free on the Internet. The image is first of all calibrated and then binarized. Then the Euclidean coordinates of each ellipse representing a cylinder oriented perpendicularly with respect to the surface are determined. The distances between each first neighbor for each of the ellipses of the image are then determined, the data are then processed by frequency of appearance and the parameters of the curve thus obtained are estimated following an adjustment of Gaussian type, making possible a precise measurement of the period.

In figure 2, the period of the various samples is given as a function of the fraction by volume of B in the A-B blend, A and B being the respective block copolymers.

The linear change in the period of the blends is clearly seen therein.

Thus, by altering the amount respectively of the two block copolymers, it is possible to finely adjust the period.

Example 2:

In this example, the advantage is shown of using blends of block copolymers in comparison with the use of a single block copolymer. In addition to the possibility of finely adjusting the period, the blends of block copolymers allow the establishment of layers of block copolymers of high thickness without defect of orientation, compared with those observed when just one block copolymer is used for these same high thicknesses (typically > 35 nm). For this, a blend of two block copolymers and a block copolymer, the period of which is equivalent (approximately 46-47 nm), are compared. The block copolymers 23 and 50, blended in proportions targeting a period of 46 nm, are compared with a sample C46 (46), the characteristics of which are as follows:

Nanostrength EO® C46:

Mn = 85.7 kg/mol
Mw/Mn = 1.16
PS/PMMA ratio by weight = 69.9/30.1
Period: 46 nm

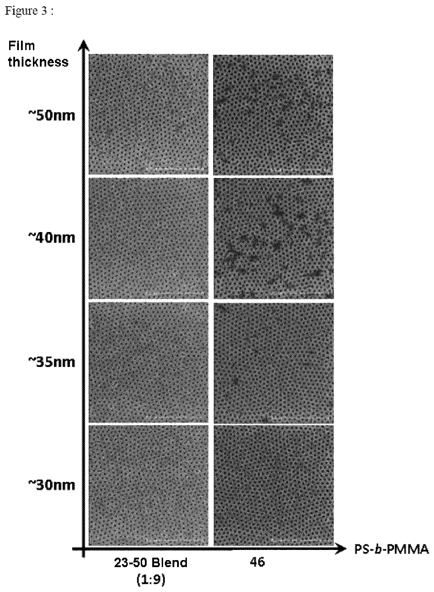

In figure 3, the 23-50 blend, compared with 46 alone, which are deposited on a surface prepared as in example 1, are considered. The advantage of using a blend to minimize the amount of defects, in this case defects of orientation, of the block copolymers is clearly seen therein. For a thickness, for example, of 40 nm and at one and the same period, while the blend does not exhibit any defect of orientation, the block copolymer used alone exhibits a very large number of defects of orientation, the dark regions corresponding to cylinders which are lying and no longer vertical.

The measurements of film thickness were carried out on a Prometrix UV1280 ellipsometer.

Example 3:

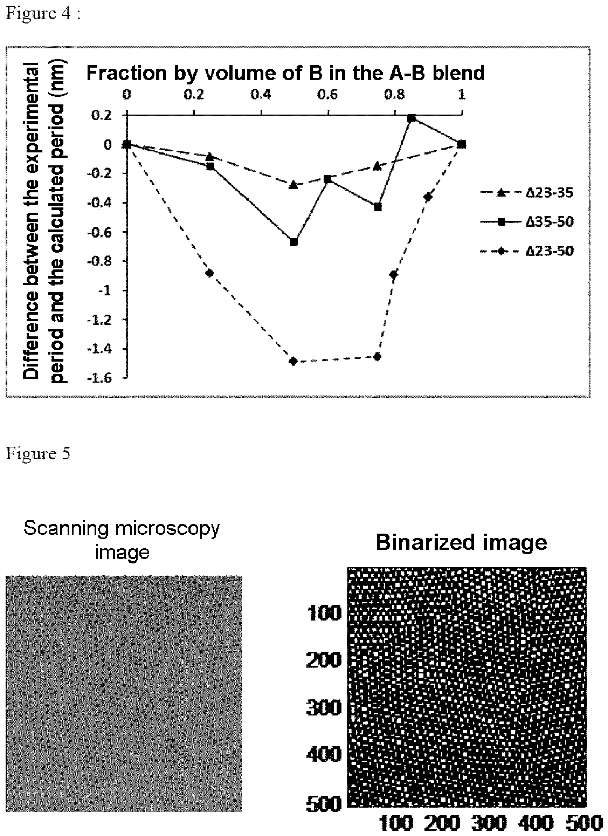

In this example, the accuracy of the prediction of the period for blends of block copolymers deposited on a surface as carried out in example 1 is evaluated in comparison with the experimental measurement. There is found therein, in figure 4, for a maximum difference of 27 nm between the periods characterizing the morphologies of two block copolymers A and B, with respective periods of 23.05 nm for A and 49.7 nm for B, a difference of approximately 1.5 nm between the prediction and the measurement.
When A takes the value of 23.05 and B the value of 34.3, this difference is in the vicinity of 0.2 nm, which demonstrates the accuracy of the method which is a subject matter of the invention.

Example 4:

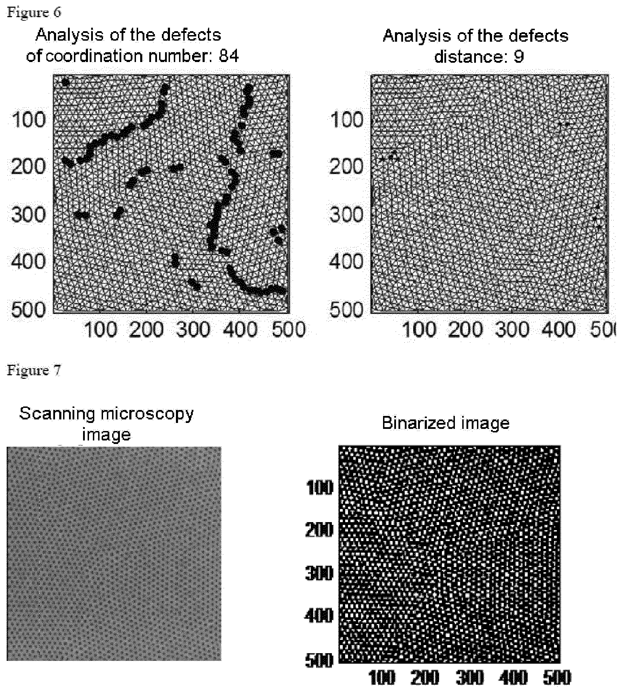

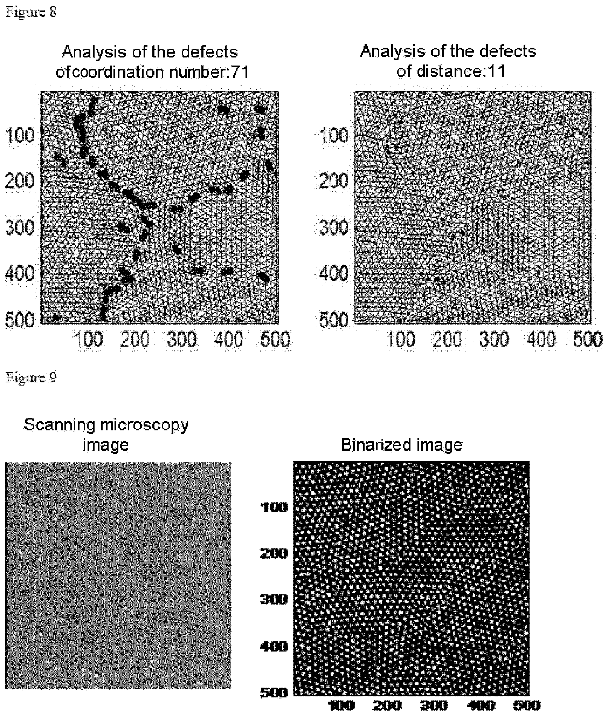

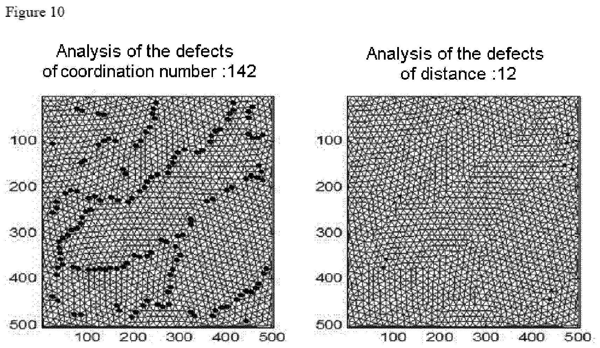

In this example, the advantage is shown of using the blends of block copolymers to reduce the defects of coordination number and of distance.
For this, the copolymer C22, with a period of 23.05 nm, is blended with the copolymer C35, with a period of 34.3 nm, in proportions by volume of 13/87. This blend is deposited according to the technique already described. Furthermore, the copolymer C35 is deposited according to the same technique already described.
The image obtained using an electron microscope (SEM) and also its binarization for the copolymer blend are visualized in figure 5.
By following the technique described in the description for the measurement of the different defects of coordination number and of distance, the defects of coordination and of distance, and also their number, are visualized in figure 6. 84 defects of coordination number and 9 defects of distance are counted.
The operation is repeated with the copolymer C22, with a period of 23.05 nm, blended with the copolymer C35, with a period of 34.3 nm, in proportions by volume of 30/70. This blend is deposited according to the technique already described.
Likewise, the SEM and binarized images are visualized in figure 7 and the defects of coordination number and of distance, and also their number, are visualized in figure 8. In this case, 71 defects of coordination number and 11 defects of distance are counted.
The operation is subsequently carried out with the copolymer C35, with a period of 34.3 nm, alone (figures 9 and 10). In this case, many more defects of coordination number (142) and slightly more defects of distance (12) are observed.
In both cases where copolymers were blended, a decrease in the number of defects, whether of coordination number or of distance, is found.

## Claims

1. A process for controlling the period of a nanostructured assemblage of a blend of block copolymers, the period, expressed in nm, following the following equation:

$$L0 = \frac{\sum_{i=1}^{n} f_i \times L0_i}{\sum_{i=1}^{n} f_i}$$

Where $f_i$ being the volumic fraction of the i block copolymer in the i solution and $L0_i$ being the period of the i block copolymer after solvent evaporation, the fraction by volume $f_i$ being defined by the IUPAC as being the volume of the component *i* in the i solution divided by the sum of the volumes of all the components in solution used to manufacture this blend,
this blend comprising n block copolymers with different molecular weights but for which at least one of the constituent monomers respectively of each of the blocks of the block copolymers is identical, n being a whole number between 2 and 5, comprising the following stages:

- blend comprising block copolymers in solution,
- deposition of this solution of blend on a surface or in a mold,
- annealing.

2. The process as claimed in claim 1, exhibiting a minimum of defects of orientation, of coordination number or of distance and large monocrystalline surfaces.

3. The process as claimed in claim 1 or 2, in which n is equal to 2.

4. The process as claimed in claim 1 or 2, in which the difference in period of the block copolymers is between 25 and 40 nm, limits included.

5. The process as claimed in claim 1 or 2, in which the difference in period of the block copolymers is between 1 and 25 nm, limits included.

6. The process as claimed in claims 4 and 5, in which the block copolymers are diblock copolymers.

7. The process as claimed in claim 6, in which the block copolymers comprise a styrene monomer.

8. The process as claimed in claim 6, in which the block copolymers comprise a methacrylic monomer.

9. The process as claimed in claim 6, in which the block copolymers are PS-PMMA copolymers.

10. The process as claimed in claim 1 or 2, in which the number-average molecular weights of the block copolymers are between 1000 and 300 000 g/mol.

11. The process as claimed in claim 6, in which the proportion by weight of a block copolymer in the blend of block copolymers varies from 1% to 99%.

12. The process as claimed in claim 1 or 2, in which the block copolymers are prepared by controlled radical polymerization.

13. The process as claimed in claim 12, in which nitroxide mediated radical polymerization is carried out.

14. The process as claimed in claim 13, in which nitroxide mediated radical polymerization is carried out, the nitroxide being N-(tert-butyl)-1-diethylphosphono-2,2-dimethylpropyl nitroxide.

15. The process as claimed in claim 1 or 2, in which the block copolymers are prepared by anionic polymerization.

16. The process as claimed in claim 1 or 2, in which the block copolymers are prepared by ring opening polymerization.

17. The process as claimed in claim 1 or 2, which makes it possible to obtain films, the thickness of which is greater than 10 nm and less than 400 nm.

18. The process as claimed in claim 1 or 2, which makes it possible to obtain films, the thickness of which is greater than 40 nm and less than 400 nm.

19. The process as claimed in claim 1 or 2, in which the surface is free.

20. The process as claimed in claim 1 or 2, in which the surface exhibits guidance structures.

21. The process as claimed in claim 1 or 2, in which the annealing is carried out by a heat treatment.

22. The process as claimed in claim 1 or 2, in which the annealing is carried out by a solvent vapor treatment.

23. The process as claimed in claim 1 or 2, in which the annealing is carried out by a combination of a heat treatment and a solvent vapor treatment.

24. The process as claimed in claim 1 or 2, in which the block copolymers exhibit a dispersity of between 1 and 3.

25. The use of the process as claimed in any one of the preceding claims to generate lithography objects, masks or nanostructured film at nanometer scale.

26. A lithography object or mask obtained according to claim 25.

**Patentansprüche**

1. Verfahren zum Steuern der Periode eines nanostrukturierten Aggregats eines Gemischs von Blockcopolymeren, wobei die Periode, ausgedrückt in nm, der folgenden Gleichung entspricht:

$$L0 = \frac{\sum_{i=1}^{n} f_i \times L0_i}{\sum_{i=1}^{n} f_i}$$

wobei $f_i$ der Volumenanteil des Blockcopolymers i in der Lösung i ist und $L0_i$ die Periode des Blockcopolymers i nach Lösungsmittelverdunstung ist, wobei der Volumenanteil $f_i$ gemäß IUPAC als das Volumen der Komponente i in der Lösung i geteilt durch die Summe der Volumen aller zur Herstellung dieses Gemischs verwendeten Komponenten in Lösung definiert ist,
wobei dieses Gemisch n Blockcopolymere mit verschiedenen Molekulargewichten umfasst, für die aber wenigstens eines der konstituierenden Monomere jeweils jedes der Blöcke der Copolymere identisch ist, wobei n eine ganze Zahl zwischen 2 und 5 ist, umfassend die folgenden Stufen:

- Gemisch, umfassend Blockcopolymere in Lösung,
- Aufbringen dieser Mischlösung auf eine Oberfläche oder in ein Formwerkzeug,
- Tempern.

2. Verfahren gemäß Anspruch 1, das ein Minimum an Defekten von Orientierung, Koordinationszahl oder Abstand und großen monokristallinen Oberflächen aufweist.

3. Verfahren gemäß Anspruch 1 oder 2, wobei n gleich 2 ist.

4. Verfahren gemäß Anspruch 1 oder 2, wobei die Differenz der Periode der Blockcopolymere zwischen 25 und 40 nm, einschließlich der Grenzen, beträgt.

5. Verfahren gemäß Anspruch 1 oder 2, wobei die Differenz der Periode der Blockcopolymere zwischen 1 und 25 nm, einschließlich der Grenzen, beträgt.

6. Verfahren gemäß Ansprüchen 4 und 5, wobei die Blockcopolymere Diblockcopolymere sind.

7. Verfahren gemäß Anspruch 6, wobei die Blockcopolymere ein Styrolmonomer umfassen.

8. Verfahren gemäß Anspruch 6, wobei die Blockcopolymere ein Methacrylmonomer umfassen.

9. Verfahren gemäß Anspruch 6, wobei die Blockcopolymere PS-PMMA-Copolymere sind.

10. Verfahren gemäß Anspruch 1 oder 2, wobei die anzahlgemittelten Molekulargewichte der Blockcopolymere zwischen 1000 und 300 000 g/mol betragen.

11. Verfahren gemäß Anspruch 6, wobei der Gewichtsanteil eines Blockcopolymers in dem Gemisch von Blockcopolymeren von 1 % bis 99 % variiert.

**12.** Verfahren gemäß Anspruch 1 oder 2, wobei die Blockcopolymere durch gesteuerte Radikalpolymerisation hergestellt werden.

**13.** Verfahren gemäß Anspruch 12, wobei nitroxidvermittelte Radikalpolymerisation durchgeführt wird.

**14.** Verfahren gemäß Anspruch 13, wobei nitroxidvermittelte Radikalpolymerisation durchgeführt wird, wobei das Nitroxid N-(tert-Butyl)-1-diethylphosphono-2,2-dimethylpropylnitroxid ist.

**15.** Verfahren gemäß Anspruch 1 oder 2, wobei die Blockcopolymere durch anionische Polymerisation hergestellt werden.

**16.** Verfahren gemäß Anspruch 1 oder 2, wobei die Blockcopolymere durch Ringöffnungspolymerisation hergestellt werden.

**17.** Verfahren gemäß Anspruch 1 oder 2, das ermöglicht, Filme, deren Dicke größer als 10 nm und kleiner als 400 nm ist, zu erhalten.

**18.** Verfahren gemäß Anspruch 1 oder 2, das ermöglicht, Filme, deren Dicke größer als 40 nm und kleiner als 400 nm ist, zu erhalten.

**19.** Verfahren gemäß Anspruch 1 oder 2, wobei die Oberfläche frei ist.

**20.** Verfahren gemäß Anspruch 1 oder 2, wobei die Oberfläche Führungsstrukturen aufweist.

**21.** Verfahren gemäß Anspruch 1 oder 2, wobei das Tempern durch eine Wärmebehandlung durchgeführt wird.

**22.** Verfahren gemäß Anspruch 1 oder 2, wobei das Tempern durch eine Lösungsmitteldampfbehandlung durchgeführt wird.

**23.** Verfahren gemäß Anspruch 1 oder 2, wobei das Tempern durch eine Kombination einer Wärmebehandlung und einer Lösungsmitteldampfbehandlung durchgeführt wird.

**24.** Verfahren gemäß Anspruch 1 oder 2, wobei die Blockcopolymere eine Dispersität von zwischen 1 und 3 aufweisen.

**25.** Verwendung des Verfahrens gemäß einem der vorstehenden Ansprüche für die Herstellung von Lithographiegegenständen, -masken oder von nanostrukturiertem Film auf den Nanometermaßstab.

**26.** Lithographiegegenstand oder -maske, erhalten gemäß Anspruch 25.

**Revendications**

**1.** Procédé pour la régulation de la période d'un assemblage nanostructuré d'un mélange de copolymères à blocs, la période, exprimée en nanomètres, suivant l'équation suivante :

$$L0 = \frac{\sum_{i=1}^{n} f_i \times L0_i}{\sum_{i=1}^{n} f_i}$$

dans laquelle $f_i$ est la fraction volumique du copolymère à blocs i dans la solution i et $L0_i$ est la période du copolymère à blocs i après évaporation du solvant, la fraction par volume $f_i$ étant définie par l'UICPA comme étant le volume du composant *i* dans la solution i divisé par la somme des volumes de tous les composants en solution utilisés pour fabriquer ce mélange,

ce mélange comprenant n copolymères à blocs dotés de différents poids moléculaires mais pour lesquels au moins l'un des monomères constitutifs respectivement de chacun des blocs des copolymères à blocs est identique, n étant un nombre entier entre 2 et 5, comprenant les stades suivants :

- mélange comprenant des copolymères à blocs en solution,
- dépôt de cette solution de mélange sur une surface ou dans un moule,
- recuisson.

2. Procédé selon la revendication 1, présentant un minimum de défauts d'orientation, de nombre de coordination ou de distance et de grandes surfaces monocristallines.

3. Procédé selon la revendication 1 ou 2, dans lequel n est égal à 2.

4. Procédé selon la revendication 1 ou 2, dans lequel la différence en période des copolymères à blocs est comprise entre 25 et 40 nm, limites incluses.

5. Procédé selon la revendication 1 ou 2, dans lequel la différence en période des copolymères à blocs est comprise entre 1 et 25 nm, limites incluses.

6. Procédé selon les revendications 4 et 5, dans lequel les copolymères à blocs sont des copolymères diblocs.

7. Procédé selon la revendication 6, dans lequel les copolymères à blocs comprennent un monomère de type styrène.

8. Procédé selon la revendication 6, dans lequel les copolymères à blocs comprennent un monomère méthacrylique.

9. Procédé selon la revendication 6, dans lequel les copolymères à blocs sont des copolymères de type PS-PMMA.

10. Procédé selon la revendication 1 ou 2, dans lequel les poids moléculaires moyens en nombre des copolymères à blocs sont compris entre 1 000 et 300 000 g/mole.

11. Procédé selon la revendication 6, dans lequel la proportion en poids d'un copolymère à blocs dans le mélange de copolymères à blocs varie de 1 % à 99 %.

12. Procédé selon la revendication 1 ou 2, dans lequel les copolymères à blocs sont préparés par polymérisation radicalaire contrôlée.

13. Procédé selon la revendication 12, dans lequel une polymérisation radicalaire médiée par un nitroxyde est mise en œuvre.

14. Procédé selon la revendication 13, dans lequel une polymérisation radicalaire médiée par un nitroxyde est mise en œuvre, le nitroxyde étant le N-(tert-butyl)-1-diéthylphosphono-2,2-diméthylpropylnitroxyde.

15. Procédé selon la revendication 1 ou 2, dans lequel les copolymères à blocs sont préparés par polymérisation anionique.

16. Procédé selon la revendication 1 ou 2, dans lequel les copolymères à blocs sont préparés par polymérisation par ouverture de cycle.

17. Procédé selon la revendication 1 ou 2, qui permet l'obtention de films, l'épaisseur desquels étant supérieure à 10 nm et inférieure à 400 nm.

18. Procédé selon la revendication 1 ou 2, qui permet l'obtention de films, l'épaisseur desquels étant supérieure à 40 nm et inférieure à 400 nm.

19. Procédé selon la revendication 1 ou 2, dans lequel la surface est libre.

**20.** Procédé selon la revendication 1 ou 2, dans lequel la surface présente des structures d'orientation.

**21.** Procédé selon la revendication 1 ou 2, dans lequel la recuisson est mise en œuvre par un traitement à la chaleur.

**22.** Procédé selon la revendication 1 ou 2, dans lequel la recuisson est mise en œuvre par un traitement par des vapeurs de solvant.

**23.** Procédé selon la revendication 1 ou 2, dans lequel la recuisson est mise en œuvre par une combinaison d'un traitement à la chaleur et d'un traitement par des vapeurs de solvant.

**24.** Procédé selon la revendication 1 ou 2, dans lequel les copolymères à blocs présentent une dispersité comprise entre 1 et 3.

**25.** Utilisation du procédé selon l'une quelconque des revendications précédentes pour générer des objets, des masques ou un film nanostructuré de lithographie, à l'échelle du nanomètre.

**26.** Objet ou masque de lithographie obtenu selon la revendication 25.

Figure 1:

Figure 2:

Figure 3 :

Figure 4 :

Figure 5

Figure 6

Analysis of the defects
of coordination number: 84

Analysis of the defects
distance: 9

Figure 7

Scanning microscopy
image

Binarized image

Figure 8

**Analysis of the defects of coordination number:71**

**Analysis of the defects of distance:11**

Figure 9

**Scanning microscopy image**

**Binarized image**

Figure 10

Analysis of the defects
of coordination number :142

Analysis of the defects
of distance :12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0749987 A
- EP 0524054 A

- WO 20121400383 A


**Non-patent literature cited in the description**

- **HADZIIOANNOU et al.** *Macromolecules,* 1982, vol. 15, 267-271
- **D. YAMAGUCHI et al.** *Macromolecules,* 2001, vol. 34, 6495-6505
- **E. SIVANIAH et al.** *Macromolecules,* 2008, vol. 41, 2584-2592
- **X. ZHANG et al.** *Macromolecules,* 2011, vol. 44, 9752-9757
- **L. KANE et al.** *Macromolecules,* 1996, vol. 29, 8862-8870
- **S. KOIZUMI et al.** *Macromolecules,* 1994, vol. 27, 4371-4381

- **W.LI ; F.QIU ; Y.YANG ; A.C.SHI.** *Macromolecules,* 2010, vol. 43, 2644
- **K. AISSOU ; T. BARON ; M. KOGELSCHATZ ; A. PASCALE.** *Macromol.,* 2007, vol. 40, 5054
- **R. A. SEGALMAN ; H. YOKOYAMA ; E. J. KRAMER.** *Adv. Matter.,* 2003, vol. 13, 1152
- **TIRON et al.** *J. Vac. Sci. Technol. B,* 2011, vol. 29 (6), 1071-1023
- **MANSKY et al.** *Science,* 1997, vol. 275, 1458-1460
- **MANSKY et al.** *Science,* 1997, 1458